# EUROPEAN PATENT APPLICATION

(11) **EP 1 956 114 A1**
(43) Date of publication of application: **13.08.2008**
(21) Application number: 07090013.9
(22) Date of filing: 30.01.2007
(51) Int. Cl.: C23C 18/31, C23C 18/42, H05K 3/24

(54) **A layer assembly, a method of forming said layer assembly and a circuit carrier comprising said layer assembly**

(71) Applicant: ATOTECH Deutschland GmbH, 19553 Berlin (DE)
(72) Inventor: Hirsekorn, Isabel-Roda, 14193 Berlin (DE); Rossenbeck, Britta, Dr., 10629 Berlin (DE); Schreier, Hans-Jürgen, Dr., 16727 Velten (DE); Sebald, Christian, 10405 Berlin (DE); Wegricht, Jens, 13088 Belin (DE); Beck, Thomas, 10559 Berlin (DE); Kuldip, Singh Johal, Rock Hill, South Carolina 29732 (US)
(74) Representative: Bressel, Burkhard

(57) **Abstract**

To achieve good solder performance with Pd-free solder to a BGA design, a layer assembly comprising first, second and, optionally, third sub-layers is provided, wherein said first sub-layer comprises a first material, said first material comprising nickel and phosphorus and said first sub-layer being in contact with said second sub-layer; said second sub-layer comprises a second material, said second material comprising palladium and phosphorus and said second sub-layer being in contact with said first sub-layer and said third sub-layer and wherein said second sub-layer is at least 0.1 µm thick; and said third sub-layer comprises a third material, said third material consisting of gold or a gold alloy and said third sub-layer being in contact with said second sub-layer. Such layer assembly is coated to the copper structure which is provided on one or on both sides of the carrier corpus of a circuit carrier.

## Description

The present invention relates to a layer assembly comprising at least first and second sub-layers, a method of forming said layer assembly and a circuit carrier comprising said layer assembly.

### Background Art

In printed circuit board (PCB) manufacturing it is required that electronic components are soldered or bonded to selected soldering or bonding areas (solder pads or bond pads, respectively) of a copper structure produced on one or on both sides of the PCB. Such interconnection must be reliable in terms of solder or bond strength, *i*.*e*., thermal stress imposed on a soldering or bonding interconnection must by no means result in a break of this interconnection.

During the relatively short history of the electronics packaging and assembly industry, few innovations have impacted the design and manufacturing sectors as much as ball grid array (BGA) technology. This interconnection technology used for interconnecting semiconductor components on the PCB involves providing a matrix of solder pads on the underside of the (housed) semiconductor component and a respective matrix of solder pads on the PCB and joining the two matrices together by soldering. To this end solder balls or solder paste are/is coated to the solder pads on the semiconductor component and the ensemble is then heated to perform soldering. Joining and heating the semiconductor component and the PCB results in melting of the solder balls or solder paste and connecting the two items together. Widespread acceptance of BGAs has occurred for most electronics applications. In the case of BGAs, the nature of the solder bond is quite different from that of the earlier leaded through-hole and SMT (surface mounted technology) components, because it is more prone to fracture due to the rigid interconnection without the possibility of alignment as a reaction to thermal stress.

Ball grid arrays have been universally accepted in reliable component packaging methodology. Soldering has been performed using lead containing solder, tin-lead solder for example, in the past. With Pb-free (lead-free) alloys for both BGA solder balls and paste now becoming the dominant bonding medium, the importance of solder joint integrity has become even more significant. Pb-free joints can be particularly susceptible to brittle fracture at the ball-to-pad interface. Such failures can occur at any stage in the full life cycle of the solder joint including manufacturing, handling, testing and end-using. Widespread adoption of Pb-free fabrication and assembly is further impacted by the continuing demand for finer circuitry and interconnect features.

In order to provide reliable solderability of copper pads on a PCB a layer assembly has been used for some time, which comprises providing the pads first with a nickel-phosphorus coating and then with a gold coating wherein the nickel-phosphorus coating is deposited from a solution in an electroless manner and wherein the gold coating is deposited from an immersion gold solution. This process is called ENIG (electroless-nickel/gold).

Traditionally, ENIG has been accepted as a surface finish for both IC substrates and PCBs for BGA applications. However, with the recent introduction of Pb-free fabrication and assembly requirements, alternative finishes are being examined. The suitability of nickel/palladium/gold finish for both wire bonding and soldering has been previously reported (J.Johal, S.Lamprecht, H.Roberts in: "Electroless Nickel / Electroless Palladium / Immersion Gold Plating Process for Gold-Aluminium-Wire Bonding Designed for High-Temperature Applications", SMTA 9th Annual Pan Pacific Microelectronics Symposium, January 2004; J.Johal, H.Roberts, S.Lamprecht in: "Electroless Nickel / Electroless Palladium / Immersion Gold Process for Multi-Purpose Assembly Technology"; SMTA International Conference; September 2004). In further studies, ball shear and Cold Ball Pull (CBP) investigations of several alternative finishes were performed, but only at the more traditional (slower) test speeds (K.Johal, H.Roberts, K.Desai, Q.H.Low; "Performance and Reliability Evaluation of Alternative Surface Finishes For Wire Bond and Flip Chip BGA Applications", SMTA 11th Annual Pan Pacific Microelectronics Symposium, January 2007). The results of these investigations indicated that the nickel/palladium/gold process provides improved bonding results for meeting the more demanding BGA soldering requirements of the tin-silver-copper alloy composition.

DE 44 31 847 C2 discloses a printed circuit board having a bondable metallic coating, said coating being a combination of a nickel or nickel alloy coating, this coating being 1-10 µm thick, a palladium containing coating, this coating being 0.01-0.5 µm thick, and a gold or gold alloy coating, this coating being 0.01-0.5 µm thick. The nickel alloy is a nickel-boron alloy, nickel-phosphorus alloy, nickel-iron-phosphorus alloy, nickel-phosphorus-tungsten alloy, nickel-cobalt-phosphorus alloy or nickel-tungsten alloy. The gold alloy is a gold-iron alloy, gold-cobalt alloy or gold-nickel alloy. The palladium containing coating may preferably be a palladium coating, palladium-nickel coating or a palladium-silver coating, the latter two coatings being combined with a 0.01-0.1 µm thick palladium coating, which enhances adherence of the coating to the nickel or nickel alloy coating.

Further, K.Tsukada in: "Development of New Surface Finishing Technology for PKG Substrate with High Bondability", Proceedings. International Symposium on Advances Packaging Materials: Processes, Properties and Interfaces, 2005, pages 110-114, describes the characteristics, development and application of the surface finishing technology for packaging substrates using an electroless nickel/palladium/gold layer. The nickel coating of the layer is a nickel-phosphorus coating which has 7 % phosphorus. Thickness of this coating is 3-5 µm. The palladium of this coating contains 5 % of phosphorus. This coating is 0.06 µm thick. The gold coating is formed using a gold potassium cyanide solution, and thickness thereof is 0.06 µm either. Wire-bondability after high temperature storage is told to be good and solderability with Pb-free solder to the connecting pads applied to this layer surface finishing is told to be excellent. Solderability using Pb-free solder has been tested using the Cold Ball Pull Test while observing the fracture mode simultaneously.

Solder bond reliability may preferably be tested using high-speed bond testing. The essence and advantage of high-speed bond testing is that at high strain rates the applied force is transferred to the bond itself. When testing at (traditional) lower shear speeds and pull speeds, the dominant failure mode tends to be within the solder ball. Such results only indicate that the bond strength is greater than that of the sheared solder ball, making it very difficult to compare the effects of different pad finishes and solder alloys. Extensive research has now shown that testing at much higher speeds will result in significantly higher incidence of bond failures, allowing the performance of different pad finishes and solder alloys to be compared (R.Sykes, "Lead free BGA reliability: High-Speed Bond Testing and Brittle Fracture Detection", Global SMT & Packaging, October 2005).

Using such high-speed bond testing, it has proved that the solder joints achieved using the metallic coatings of DE 44 31 847 C2 and of K.Tsukada, *ibid*., do not result in sufficiently reliable solder bonds.

It is therefore an object of the present invention to provide a layer assembly to be deposited on a circuit carrier's surface that ensures good reliability of solder bonds to be formed especially in BGA technology.

It is a another object of the present invention to provide a layer assembly to be deposited on a circuit carrier's surface that ensures good reliability of solder bonds to be confirmed with high-speed bond testing.

It is still another object of the present invention to provide a method of forming said layer assembly while allowing for good solderability of solder bonds to be formed thereon.

It is still another object of the present invention to provide a circuit carrier, said circuit carrier having a copper structure, wherein the copper structure is coated with the layer assembly.

### Summary of the Invention

To achieve these objects, the present invention provides a layer assembly, this layer assembly comprising at least first and second sub-layers and preferably additionally a third sub-layer: Said first sub-layer comprises a first material, said first material consisting of nickel and phosphorus and optionally of any other material like cobalt. Said first sub-layer is in contact with said second sub-layer. Further said second sub-layer comprises a second material, said second material comprising palladium and phosphorus. Said second sub-layer is in contact with said first sub-layer and, if applicable, with said third sub-layer. Said second sub-layer is at least 0.1 µm, more preferably at least 0.15 µm and most preferably at least 0.2 µm thick. Said third sub-layer comprises a third material, said third material consisting of gold or of a gold alloy. Said third sub-layer is in contact with said second sub-layer. Thus, the layer assembly of the invention comprises two sub-layers or, optionally three sub-layers, which are sequentially stacked over each other, said first sub-layer being a nickel-phosphorus sub-layer and being coated on the metal structure of the circuit carrier, said second sub-layer being a palladium-phosphorus sub-layer and being coated onto the first sub-layer and, if applicable, said third sub-layer being a gold or gold alloy sub-layer and being coated onto the second sub-layer.

This layer assembly is coated to the metal structure, more specifically the copper structure, which is provided on a circuit carrier. Such circuit carrier comprises a carrier corpus and the metal structure, more specifically copper structure, which is provided on one or both sides of said carrier corpus. Hence, the metal structure is coated with the layer assembly which comprises said first and second sub-layers and, optionally, said third sub-layer. The layer assembly is preferably coated onto those metal structures which are solder pads.

The term "circuit carrier" as used herein refers to a device that is comprised of one or a plurality of planes in which are located conductor lines and which are separated from each other by dielectric layers. Such devices may be integrated circuit electronic devices, hybrid circuits like multichip modules and printed circuit boards or the like.

The copper structure comprises solder and bond pads, which serve the connection of electronic components to the circuit carrier, conductor lines, which serve the electrical connection between pads and between metallized holes and pads, and other conductor areas, like ground areas, shielding areas and the like.

For forming the layer assembly of the invention on the copper structures of a circuit carrier, a method of the invention is provided which comprises the steps of providing the circuit carrier which comprises a carrier corpus and a metal structure, more specifically a copper structure, which structure is provided on one or on both sides of said carrier corpus; depositing onto said copper structure said first sub-layer and then depositing onto said first sub-layer said second sub-layer. Onto said second sub-layer may be deposited finally a third sub-layer.

In contrast to prior art, the layer assembly of the present invention provides for most reliable solder connections between an electronic component and the circuit carrier, more specifically between respective bond pads on the electronic component and on the circuit carrier, respectively, and especially in BGA technology.

In order to reliably verify solderability of the connections to be formed in BGA technology, new testing methodologies have been adopted to augment the data resulting from more traditional solder spreading and wetting evaluations. Consequently, new test methods, namely the Ball Shear Test and the Cold Ball Pull Test, have been used. These test methods represent two relatively fast and simple methods for measuring the effectiveness of bonding achieved through reflow of BGA solder balls. However, there have been some recent developments that may raise questions regarding the applicability of previously obtained test data. Most of the global electronics producers are now actively responding to the newly effective Pb-free requirements. The electronics manufacturing chain, including material suppliers, IC substrate fabricators, EMS/ODM companies, and OEMs, is continuing to learn about Pb-free assemblies. In some cases, parameters for testing methodologies are also changing in response to the combined effect of continued miniaturization and Pb-free requirements.

Solder ball shear testing is performed by shearing off a solder ball applied to a solder pad on a PCB substrate with a bit, this bit being positioned to perform shearing the ball off at a defined height relative to the pad/solder ball-interface and parallel to it. Cold ball pull testing is performed by gripping a solder ball applied to a solder pad on a PCB (more general: circuit carrier) substrate and, while accelerating the gripping means, pulling the solder off the pad.

Using the inventive layer assembly having a palladium-phosphorus (PdP) sub-layer which is at least 0.1 µm thick, preferably at least 0.15 µm thick and most preferably 0.2 µm thick, proved to be much more reliable as to bond strength than those layers which comprise a sub-layer that comprises (pure) palladium, but not phosphorus and/or that is less than 0.1 µm, more preferably less than 0.15 µm and most preferably less than 0.2 µm thick. The thicker this layer is, the more reliable solderability has found to be. Both, solder ball shear testing and cold ball pull testing have shown that the fracture mode detected with these tests will in almost all cases be ball failure, *i*.*e*., the solder ball is broken whereas the interface between the solder ball and the pad remains intact.

According to a preferred embodiment of the invention the second sub-layer is at least 0.3 µm thick. The second sub-layer may be at most 2.0 µm, more preferably at most 1.0 µm and most preferably at most 0.7 µm thick.

Further, according to another preferred embodiment of the invention the second material consists of from 90 wt.-% to 98 wt.% of palladium and from 10 wt.-% to 2 wt.-% of phosphorus, more preferably from 92 wt.-% to 96 wt.-% of palladium and from 8 wt.-% to 4 wt.-% of phosphorus and most preferably from 94 wt.-% to 96 wt.-% of palladium and from 6 wt.-% to 4 wt.% of phosphorus.

Further, according to another preferred embodiment of the invention the first sub-layer is from 3 µm to 15 µm and most preferably from 5 µm to 10 µm thick.

Further, according to another preferred embodiment of the invention the first material consists of from 87 wt.-% to 96 wt.-% of nickel and from 13 wt.-% to 4 wt.-% of phosphorus, more preferably from 90 wt.-% to 95 wt.-% of nickel and from 10 wt.-% to 5 wt.-% of phosphorus and most preferably from 90 wt.-% to 93 wt.-% of nickel and from 10 wt.-% to 7 wt.-% of phosphorus.

Further, according to another preferred embodiment of the invention the third sub-layer is from 10 nm to 100 nm thick, more preferably from 10 nm to 60 nm thick and most preferably from 10 nm to 20 nm thick.

The method of the invention preferably comprises depositing each of said first and second sub-layers and, if applicable, said third sub-layer by at least one of electroless and immersion plating. More preferably, the first sub-layer comprising nickel and phosphorus (NiP) is deposited using an electroless plating method, the second sub-layer comprising palladium and phosphorus (PdP) also using an electroless plating method and, if applicable, the third sub-layer comprising gold or a gold alloy using an electroless plating method or an immersion plating method. Electroless (autocatalytic) plating involves depositing the metal by reducing same with the help of a reducing agent which is contained in the electroless plating solution, this reducing agent being oxidized thereupon. Immersion plating involves depositing the metal by reducing same with the help of the substrate metal to which the metal will be deposited. The substrate metal will thereupon be oxidized and hence dissolve. No reducing agent being contained in the plating solution is used in this case.

The first sub-layer may preferably be deposited by bringing said printed circuit board into contact with a solution containing a nickel ion source and a phosphorus containing reducing agent.

More preferably the solution used to deposit a nickel-phosphorus sub-layer in an electroless manner is aqueous and contains a nickel salt, such as nickel sulfate, a hypophosphite containing compound like sodium or potassium hypophosphite or hypophoshporic acid, as a reducing agent, pH ajusting agents, like acetic acid and acetate containing compounds, like sodium or potassium acetate, or, alternatively, borate ion containing compounds, like boric acid and the salts thereof like borax, complexing agents, like malic acid, succinic acid, maleic acid, lactic acid, citric acid, itaconic acid as well as the salts thereof, like the sodium or potassium salts, stabilizing compounds like thiourea and the derivatives thereof, lead compounds, like lead(II) salts, and acetylenic compounds.

Further, the second sub-layer may preferably be deposited by bringing said printed circuit board into contact with a solution containing a palladium ion source and a phosphorus containing reducing agent.

More preferably the solution used to deposit the palladium-phosphorus sub-layer in an electroless manner is aqueous and contains a palladium salt, such as palladium chloride or palladium sulfate, a hypophosphite containing compound as a reducing agent like sodium or potassium hypophosphite or hypophoshporic acid, pH ajusting agents, like mineral acids, such as sulfuric acid and hydrochloric acid, or mineral bases, like sodium or potassium hydroxide, complexing agents, like amine compounds, such as ethylene diamine, and, if necessary, stabilizing compounds.

Further, the third sub-layer may preferably be deposited by bringing said circuit carrier into contact with a solution containing a gold ion source and a complexing agent.

More preferably a solution used to deposit a gold or gold alloy sub-layer by immersion plating is aqueous and contains a gold salt, which is preferably complexed, such as potassium gold cyanide, pH adjusting agents, like mineral acids, such as sulfuric acid, complexing agents, like cyanide containing compounds, such as sodium or potassium cyanide, and, if necessary, stabilizing compounds. The gold alloy sub-layer may be a gold-iron alloy, a gold-cobalt alloy or a gold nickel alloy. In order to deposit such an alloy sub-layer, an additional metal component, comprising the ion of the metal to be co-deposited, has to be added to the immersion plating bath. Complexing agents suitable to control electrochemical potential of the co-metal of the alloy will also have to be comprised in the alloy plating bath, in order to adjust alloy composition. If the third sub-layer is to be plating in an electroless manner, the plating solution additionally contains a suitable reducing agent.

In a further preferred embodiment of the invention, one or both sides of the circuit carrier corpus is/are provided with a conformal mask, said conformal mask covering all regions on said one or both sides of said carrier corpus except those regions on said one or both sides where the layer assembly is to be coated on the copper structure. The conformal mask may preferably be a solder mask, like an exposable and developpable mask. Such mask can be based on epoxy resin for example and is laminated, spin-coated, roller-coated or the like to the surface(s) of the circuit carrier. Thereafter it is exposed to actinic light and developped to uncover those regions on the surface(s) where the layer assembly is to be deposited. It is these regions where the pads are to be provided, which serve the forming of solder connections between the circuit carrier and electronic components, such as semiconductor components, which have a BGA. The conformal mask may be formed such that the uncovered regions on the surface(s) of the circuit carrier are larger than the pads formed in the copper structure, thereby exposing parts of dielectric surface regions of the circuit carrier, or smaller than the pads formed in the copper structure, such that only the pads formed in the copper structure are uncovered.

### Brief Description of the Drawings

The following Figures and Examples are presented to provide a more thorough understanding. These Figures and Examples are not to be construed as to be limiting.
- Fig. 1: shows an example of the BGA test vehicle used for investigations; this BGA test vehicle was used for solder ball shear and ball pull testing showing the location of solder balls tested and a detail of four-point anchor design (under the solder mask);
- Fig. 2: shows a Pb-free solder reflow profile (air atmosphere);
- Fig. 3: is an illustration of the ball shear test mechanism (SM: solder mask);
- Fig. 4: is an illustration of ball shear fracture modes and the location within the solder ball joint;
- Fig. 5: shows examples of ball shear fracture type showing Modes 2, 3, 4 and 5, from left to right;
- Fig. 6: is an illustration of the high-speed cold ball pull test mechanism;
- Fig. 7: is an illustration of cold ball pull failure modes and of the location within the solder ball joint;
- Fig. 8: shows leverage plots for ball shear results (above) and cold ball pull results (below) showing relatively minor influence of nickel thickness on failure mode;
- Fig. 9: shows a legend for Figs. 10-16;
- Fig. 10: is a summary of solder ball shear forces and of fracture modes at the ENIG-1, ENIG-2 and NiP/PdP/Au ("NiPdAu") surface finish for 0.3 mm/sec, 20 mm/sec and 1000 mm/sec ball shear speeds (SRO = 650 µm);
- Fig. 11: is a summary of solder ball shear forces and of the fracture modes at the ENIG-1, ENIG-2 and NiP/PdP/Au ("NiPdAu") surface finish for SROs of 450 µm, 550 µm and 650 µm (shear speed: 1000 mm/sec);
- Fig. 12: is a summary of solder ball shear fracture modes at the ENIG-1, ENIG-2 and NiP/PdP/Au ("NiPdAu") surface finish for SROs of 450 µm, 550 µm and 650 µm (shear speed: 1000 mm/sec);
- Fig. 13: is a summary of cold ball pull forces and fracture modes at the ENIG-1, ENIG-2 and NiP/PdP/Au ("NiPdAu") surface finish for 5 mm/sec and 100 mm/sec ball pull speeds (SRO: 650 µm);
- Fig. 14: is a summary of cold ball pull forces and fracture modes at the ENIG-1, ENIG-2 and NiP/PdP/Au ("NiPdAu") surface finish for SROs of 450 µm, 550 µm and 650 µm (pull speed: 5 mm/sec);
- Fig. 15: is a summary of cold ball pull fracture modes at the ENIG-1, ENIG-2 and NiP/PdP/Au ("NiPdAu") surface finish for SROs of 450 µm, 550 µm and 650 µm (pull speed: 5 mm/sec);
- Fig. 16: shows a summary of solder ball shear fracture modes (Fig. 16a) and of cold ball pull fracture modes (Fig. 16b) for ENIG-1 ("ENIG 8 %"), ENIG-2 ("ENIG 12 %"), NiP/Pd/Au ("NiPdAu"; pure palladium sub-layer) and NiP/PdP/Au ("NiPd(P)Au": 5 µm NiP, 0.1 µm PdP, 0.02 µm Au) surface finish for SROs of 650 µm following one reflow (shear speed: 1000 mm/sec and pull speed: 5 mm/sec, respectively);
- Fig. 17: shows SEM images of a cross-section of a NiP/PdP/Au solder ball after brittle fracture due to bond failure showing a detail of (Cu,Ni)₆Sn₅ IMC, which forms the fracture interface;
- Fig. 18: shows SEM images of a cross-section of a NiP/PdP/Au solder ball at 2000X magnification (above) and 5000X magnification (below) showing the formation of (Cu,Ni)₆Sn₅ IMC on a NiP/PdP/Au finish with 0.05 µm PdP, following one reflow;
- Fig. 19: shows SEM images of a cross-section of a NiP/PdP/Au solder ball at 2000X magnification (above) and 5000X magnification (below) showing the formation of (Cu,Ni)₆Sn₅ IMC on a NiP/PdP/Au finish with 0.3 µm PdP, following one reflow;
- Fig. 20: shows SEM images of a cross-section of a NiP/PdP/Au solder ball at 2000X magnification (above) and 5000X magnification (below) showing the formation of (Cu,Ni)₆Sn₅ IMC on a NiP/PdP/Au finish with 0.05 µm PdP, following five reflows;
- Fig. 21: shows SEM images of a cross-section of a NiP/PdP/Au solder ball at 2000X magnification (above) and 5000X magnification (below) showing the formation of (Cu,Ni)₆Sn₅ IMC on a NiP/PdP/Au finish with 0.3 µm PdP, following five reflows;
- Fig. 22: shows SEM images of a cross-section of a NiP/Pd/Au (pure palladium sub-layer) solder ball at 2000X magnification (above) and 5000X magnification (below) showing the formation of (Cu,Ni)₆Sn₅ IMC on a NiP/Pd/Au finish with 0.1 µm pure Pd, following five reflows.

### Detailed Description of the Invention

A major design of experiment (DOE) was conducted to compare the solder joint reliability of two different surface finishes, electroless nickel-phosphorus / immersion gold (ENIG, Comparative Example) and electroless nickel-phosphorus / electroless palladium-phosphorus / immersion gold (NiP/PdP/Au, Example of the Invention). ENIG has long been used as a surface finish within the PCB and IC (integrated circuit) substrate fabrication sectors. The NiP/PdP/Au finish was introduced more than ten years ago, but is receiving renewed attention because of its suitability for both Pb-free soldering and wire bonding applications.

To evaluate the reliability of Pb-free solder joints on nickel-based surface finishes, the two different testing methodologies were used which have been indicated herein before, the ball shear test and the cold ball pull test. The evaluation includes a comparison of results for both, conventional and higher shear and pull speeds. In addition to surface finish deposit thickness, variables also included solder ball diameter and solder resist opening (SRO; this parameter relates to a circular opening in the resist coating exposing the solder pad of the copper structure; in this design the solder resist opening was designed such that the resist still covered part of the pad and no bare epoxy adjacent to the pad was exposed).

### Test Vehicle

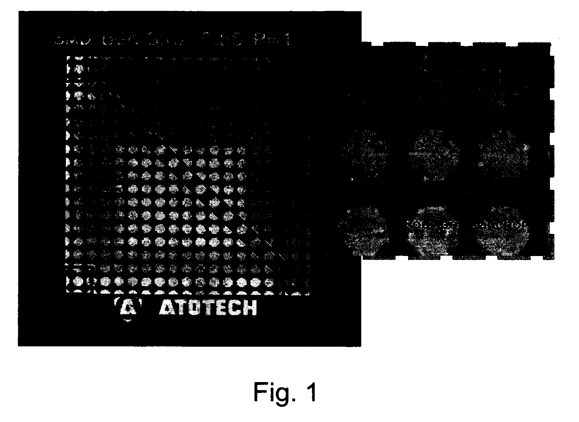

Figure 1 shows an example of the BGA test vehicle (230 mm x 166 mm) used for these investigations. Copper in these tests comprised base copper having 6 µm thickness and electroplated bright copper having 14 µm thickness. SRO in these tests was 450 µm (with pad diameter being 700 µm) or 550 µm (with pad diameter being 860 µm) or 650 µm (with pad diameter being 900 µm). Also shown are the locations of the solder balls tested in both examinations. As shown, four balls are located at each of the remote corners of the grid array and the remaining 14 balls are located diagonally across the center of the array.

The objective of the DOE was to evaluate solder joint reliability of alternative surface finishes. Therefore, it is important to note that the test vehicle, including both, the base material and pad design, was intentionally designed to be conducive to interfacial fractures between solder and pad finish (or failure within the bulk solder). To accomplish this objective, FR4 HTG material (flame retardant epoxy laminate, reinforced with glass web, 1.5 mm thick, high Tg) was selected for construction of the test vehicle. Typical build-up material for IC substrate applications does not provide sufficient adhesive strength to withstand the aggressive forces of the ball shear and ball pull bond testing. As a result, most failures would occur as a loss of adhesion between the copper pad and the underlying dielectric; thus, the bond at the surface finish would never be fully tested. FR4 was selected as the dielectric because of its inherently higher adhesive strength (approximately 50-70% greater than build-up materials). Furthermore, all pads were designed to include a "four-point anchoring" feature (shown in detail in Figure 1). This construction method also promotes the occurrence of interfacial failures by firmly securing the test pads to the underlying dielectric. Probimer 65 was used as the solder mask system after MECetchBond (CZ-81 00). Solder mask height was 22-24 µm and solder mask edges were perpendicular.

### Surface Finish

The test vehicles were fabricated with two different surface finishes: Electroless nickel-phosphorus / immersion gold (ENIG) and Electroless nickel-phosphorus / electroless palladium-phosphorus / immersion gold (NiP/PdP/Au). Table 1 presents a summary of the surface finishes included in the investigations. As shown, two versions of the ENIG surface finish (ENIG-1, ENIG-2) were examined, differing primarily in terms of the content of co-deposited phosphorus in the nickel layer and the resultant achievable immersion gold thickness (gold thickness achieved with immersion plating is dependent on phosphorus content in the nickel-phosphorus coating). Several variations of the NiP/PdP/Au finish were included in the test matrix, incorporating different deposit thicknesses and/or compositions.

**Table 1: Summary of Surface Finish Specifications**

| | NiP | PdP | Au |
|---|---|---|---|
| ENIG-1 | 4.8 µm / 8-9 wt.-% P | | 0.06 µm |
| ENIG-2 | 4.8 µm / 11-12 wt.-% P | | |
| NiP/PdP/Au-1 *) | 3.0-7.0 µm / 7-10 wt.-% P | 0.05 µm / 4-6 wt.-% P | 0.01-0.02 µm |
| NiP/PdP/Au-2 *) | 3.0-7.0 µm / 7-10 wt.-% P | 1.0 µm / 4-6 wt.-% P | 0.01-0.02 µm |
| NiP/PdP/Au-3 *) | 3.0-7.0 µm / 7-10 wt.-% P | 3.0 µm / 4-6 wt.-% P | 0.01-0.02 µm |
| Deposit thickness variations: Ni: ± 5%, Pd: ±10% Au: ±10% | | | |

| | | | |
|---|---|---|---|
| *) Also: "NiPdAu-1", "NiPdAu-2" and "NiPdAu-3", respectively | | | |

The plating baths used for the investigations were as follows:

### ENIG (Comparative Example):

Nickel-phosphorus: Aurotech^{®} CNN (Aurotech being a trade mark of Atotech Deutschland GmbH, Germany), this bath solution containing nickel sulfate (Ni²⁺ content being 6 g/I), sodium hypophosphite as the reducing agent, thiourea and Pb²⁺ as stabilizing agents, carboxylic acids as the complexing agents, pH: 4.8, T: 86°C, treatment time depending on thickness to be achieved;
Gold: Aurotech^{®} SF Plus, this bath solution containing potassium gold(I) cyanide (Au⁺ content being 2 g/I), complexing agent, pH: 4.8, T: 85°C.

### NiP/PdP/Au (Example according to the Invention):

Nickel-phosphorus: Aurotech^{®} CNN (Aurotech being a trade mark of Atotech Deutschland GmbH, Germany), this bath solution containing nickel sulfate (Ni²⁺ content being 6 g/I), sodium hypophosphite as the reducing agent, thiourea and Pb²⁺ as stabilizing agents, carboxylic acids as the complexing agents, pH: 4.8, T: 86°C, treatment time depending on thickness to be achieved;
Palladium-phosphorus: palladium chloride (Pd²⁺ content being 0.6 g/I), sodium hypophosphite · 1 H₂O (content being 4.8 g/l) as the reducing agent, ethylene diamine (content being 10 g/I) as a complexing agent, pH: 6.5, T: 55°C;
Gold: Aurotech^{®} SF Plus, this bath solution containing potassium gold(I) cyanide (Au⁺ content being 2 g/I), complexing agent, pH: 4.8, T: 85°C.

### Assembly Issues

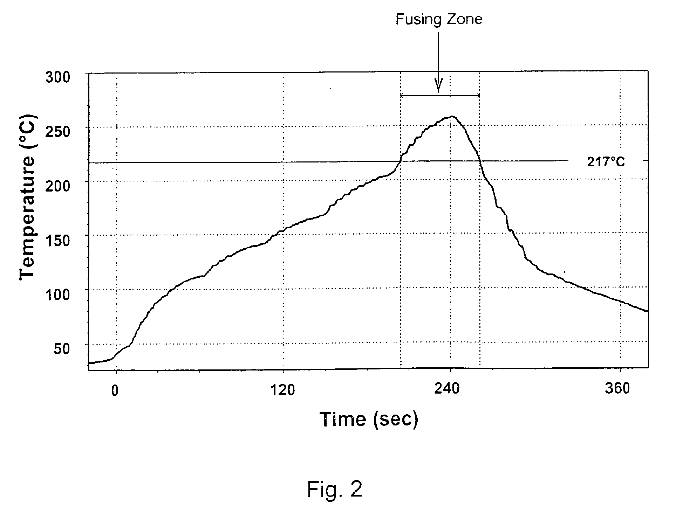

Table 2 summarizes the key information regarding assembly of the solder balls to the BGA test vehicle. As noted, a Pb-free 96.5Sn-3.0Ag-0.5Cu (SAC305) alloy solder was used for all investigations. Similar results can be obtained with a 95.5Sn-4.0Ag-0.5Cu (SAC405) alloy solder. Prior to solder reflow, all test vehicles were thermally pretreated for 12 hours at 155°C to simulate actual assembly conditions. All solder testing was performed within four hours of reflow. The solder reflow profile that was used for all investigations is shown in Figure 2.

**Table 2: Solder Ball Reflow Specifications**

| Solder Balls | Senju 96.5Sn3.0Ag0.5Cu |
|---|---|
| Solder Flux: | Kester TSF6502 |
| Reflow profile | TSF6502 Pb-free linear profile; air atmosphere |
| Peak temperature | 258°C |
| Time to peak | 241 sec |
| Time above liquidus | 57 sec |

### Test Procedures - Solder Ball Shear

Solder ball shear testing was performed at different shear speeds and with different solder resist openings (SRO) and solder ball diameters. Each test condition was specifically defined by the following:
- One of five surface finishes and plating thickness configurations (ENIG or NiP/PdP/Au);
- One of three shear speeds;
- One of three solder resist openings/ball diameters.

Table 3 presents a summary of the important parameters related to the ball shear investigations.

**Table 3: Solder Ball Shear Test Parameters**

| Equipment (low speed) | Dage Series 4000 |
|---|---|
| Equipment (high speed) | Dage Series 4000HS |
| Shear speed (low) | 0.3 mm/sec |
| Shear speed (medium) | 20 mm/sec |
| Shear speed (high) | 1000 mm/sec |
| Shear height | 50µm |
| Solder resist openings | 450 µm / 550 µm / 650 µm |
| Solder ball diameters | 600 µm / 760 µm |
| Solder ball composition | 96.5Sn-3.0Ag-0.5Cu |

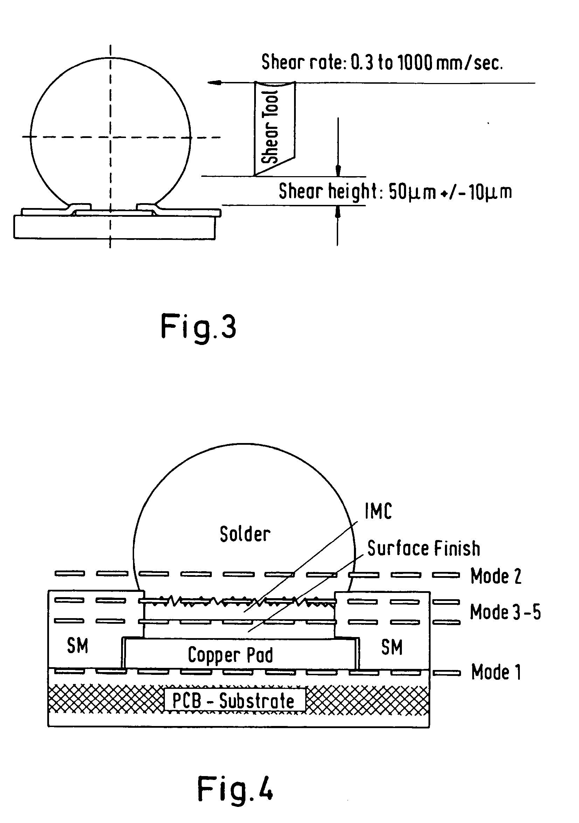

All solder balls were mounted on solder resist-defined pads. Solder resist openings (SRO) of 550 µm and 650 µm were used in conjunction with solder balls of 760 µm diameter. Solder resist openings of 450 µm were used with solder balls of 600 µm diameter. Slow-speed shear testing (0.3 mm/sec) was performed on a Dage Series 4000 Multi-Function Bond Tester, while higher speed testing (HSS: 20 mm/sec and 1000 mm/sec) was performed on a Dage Series 4000HS High-Speed Bond Tester. For each test condition, investigations included the shearing of thirty Pb-free solder balls (as located in Figure 1). An illustration of the ball shear test mechanism is shown in Figure 3.

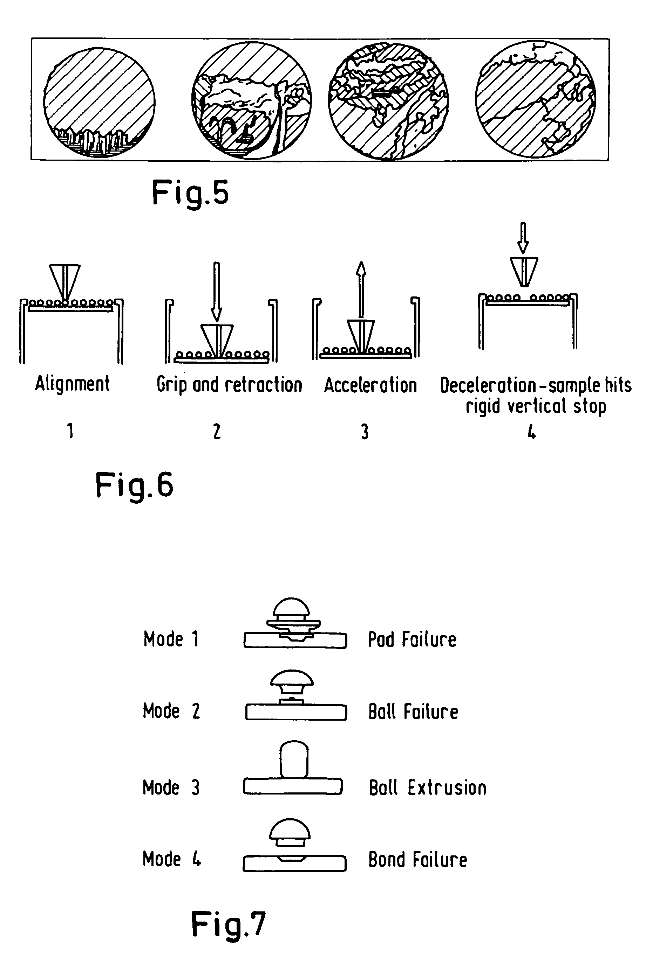

Ball shear failures were categorized according to the type and location of fracture. For ball shear, the preferred type of failure occurs entirely within the solder ball, indicative of a ductile fracture. In contrast, brittle fracture occurs primarily at the interface between the solder and the surface finish, often in combination with shearing of a portion of the solder. Failure by pad pull-out (Mode 1) only indicates that the bond of the solder ball to the pad was stronger than the pad-to-substrate adhesive strength. Figure 4 illustrates the location of the five different ball shear fracture modes within the solder ball joint. Similarly, Figure 5 shows examples of the fracture interface for failure modes 2 though 5.

### Test Procedures - Cold Ball Pull (CBP)

Cold ball pull investigations also included the testing of thirty Pb-free solder balls, as located in Figure 1, for each test condition. Similar to the shear testing, cold ball pull testing was performed at different speeds and with different solder resist openings (SRO) and solder ball diameters. Each test condition was specifically defined by the following:
- One of five surface finishes and plating thickness configurations (ENIG or NiP/PdP/Au);
- One of two pull speeds;
- One of three solder resist openings/ball diameters.

All solder balls were mounted on solder resist-defined pads in the same fashion as previously described for the ball shear investigations. Cold ball pull testing at the slower speed (5 mm/sec) was performed on the Dage 4000 Multi-Function Bond Tester, while the higher speed pull testing (100 mm/sec) was performed on the Dage 4000HS High-Speed Bond Tester. Table 4 presents a summary of the important parameters related to the cold ball pull investigations.

**Table 4: Cold Ball Pull Test Parameters**

| Equipment (low speed) | Dage Series 4000 |
|---|---|
| Equipment (high speed) | Dage Series 400HS |
| Ball pull speed (low) | 5 mm/sec |
| Ball pull speed (high) | 100 mm/sec |
| Solder resist opening | 450 µm / 550 µm / 650 µm |
| Solder ball diameter | 600 µm / 760 µm |
| Solder ball composition | Sn-3.0Ag-0.5Cu |

Figure 6 shows an illustration of the high-speed cold ball pull test mechanism.

Similar to the ball shear investigations, cold ball pull failures were also categorized according to the type and location of failure. As was the case with ball shear testing, with cold ball pull testing the preferred type of failure also occurs entirely within the solder ball (Mode 2). A bond failure (Mode 4) is indicative of brittle fracture, although in the case of cold ball pull testing the complete IMC (intermetallic compound) is typically exposed. Any combination of IMC and solder at the plane of fracture is treated as a bond failure. Again, pad failure or pad pull-out (Mode 1) only indicate that the bond of the solder ball to the pad was stronger than the pad-to-substrate adhesive strength. Ball extrusion (Mode 3) may indicate a problem with the clamping force of the device or that the solder is too soft.

Figure 7 illustrates the location of the four different fracture modes within the solder ball joint.

It has been reported that pull strength increases with test speed and that the rate of interfacial solder joint fracture increased with test speed. The same investigation noted that at high test speeds, a greater force is transferred from the solder ball to the bond between the ball and pad-interconnect, resulting in a test that examines bond reliability (L.Peters; "Lead-Free Brings Out Problem of Brittle Fracture"; Semiconductor International; September 2005).

In comparison to ball shear, cold ball pull testing is a newer technique for determining solder joint reliability that the packaging industry is slowly adopting. This method uses a plain tensile load, as opposed to the traditional ball shear test that employs a combination of tensile and compressive loading. Cold ball pull testing offers another methodology for measuring interfacial bond strength in a relatively fast, low-cost manner.

### Testing Results

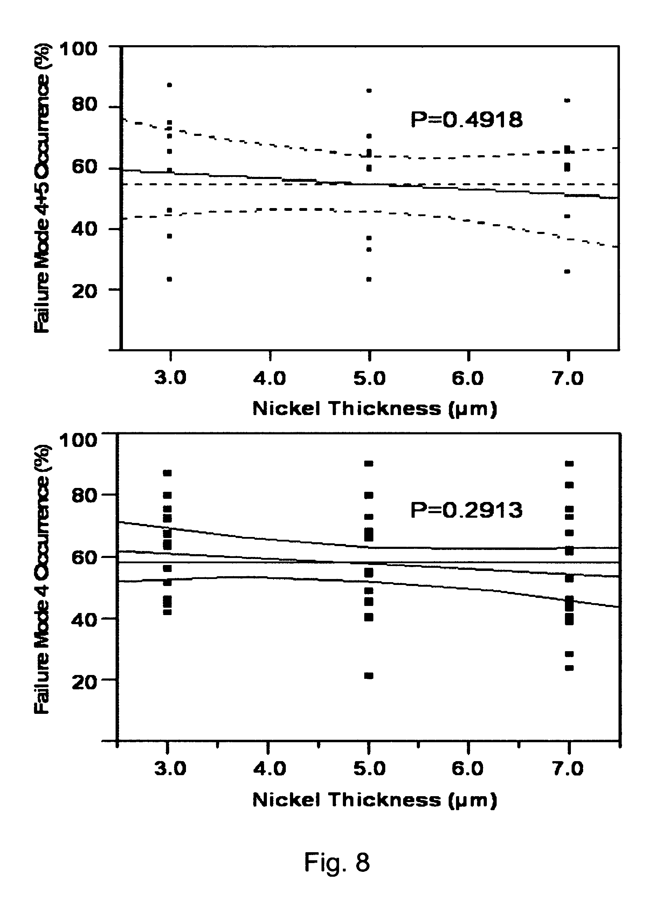

The DOE reflected herein above resulted in a significant amount of data, requiring both compilation and statistical analysis. In particular, much effort was devoted to "screening" the various parameters associated with the NiP/PdP/Au finish. To determine the influence of each test parameter for the NiP/PdP/Au finishes, linear regression analyses of failure modes were performed with ball shear and ball pull results using the factors of nickel-phosphorus thickness, palladium-phosphorus thickness and solder resist opening. For this examination, failure modes 4 and 5 were included in the ball shear analysis, while failure mode 4, alone, was used for the cold ball pull analysis. Palladium thickness and SRO were found to significantly impact test results in terms of both ball shear and cold ball pull testing. However, the analysis also indicated that the nickel deposit thickness had only a relatively minor effect on the results of both the ball shear and cold ball pull testing. This finding is presented in Figure 8 by the two leverage plots showing the effect of nickel deposit thickness on the occurrence of brittle fracture for the two test methodologies.

### Testing Results - Solder Ball Shear

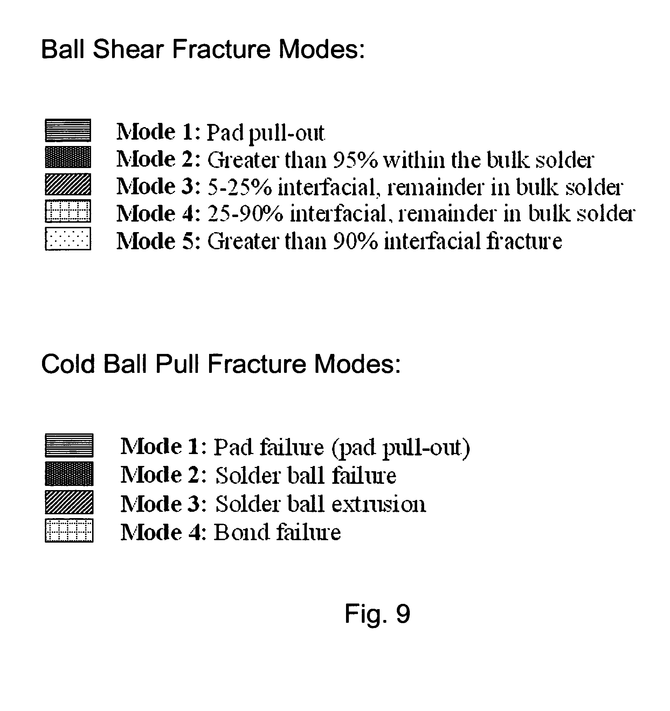

The guidelines and graphics legend for qualifying the five types of ball shear failures are given in Figure 9.

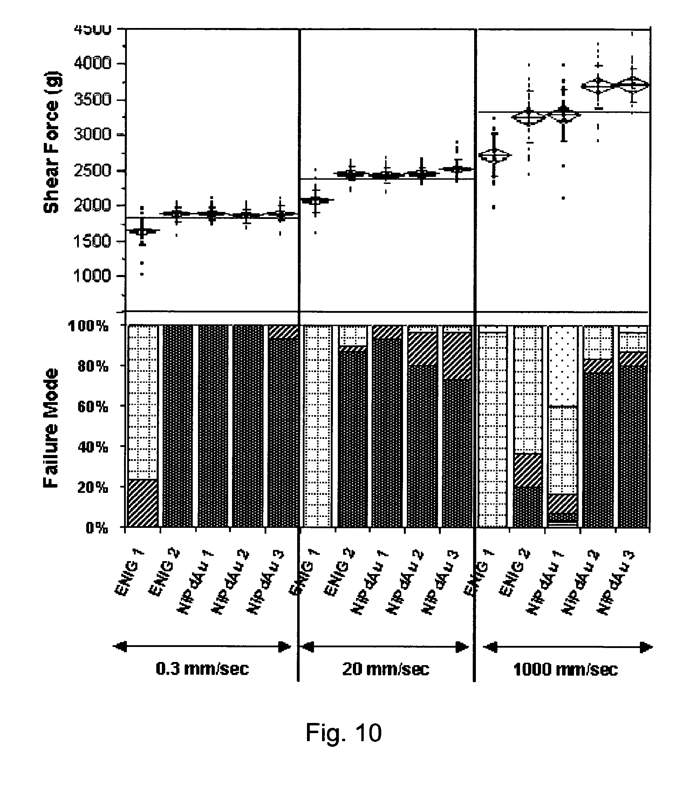

The effect of increasing shear speed on the solder ball shear test is graphically presented in Figure 10. This investigation was limited to the SRO diameter of 650 µm. As expected, there is a distinct trend of increasing shear forces with increasing shear speeds. Likewise, according to the failure mode section of Figure 10, there is also a trend of increasing incidence of interfacial fracture with increasing shear speeds. However, measurable differences among the finishes are evident within each shear speed segment. For all shear speeds, the ENIG-2 deposit yielded better results than the ENIG-1 (with a medium phosphorus content). More importantly, the NiP/PdP/Au surface finishes with thicker palladium deposits (0.2 µm and 0.3 µm) can withstand measurably greater shear forces and provide a significantly higher percentage of ductile (Mode 2) failures compared to the other surface finishes. This fact is best demonstrated at the highest shear speed, reflecting more disparity in both shear force and failure mode results. Generally, these findings indicate that shear force and failure mode results are affected by both the phosphorus content in the ENIG nickel deposit and the palladium thickness of the NiP/PdP/Au finish impacts. Furthermore, the use of the highest ball shear speed increases the incidence of brittle interfacial fracture and would appear to provide a more demanding test of solder ball bond strength.

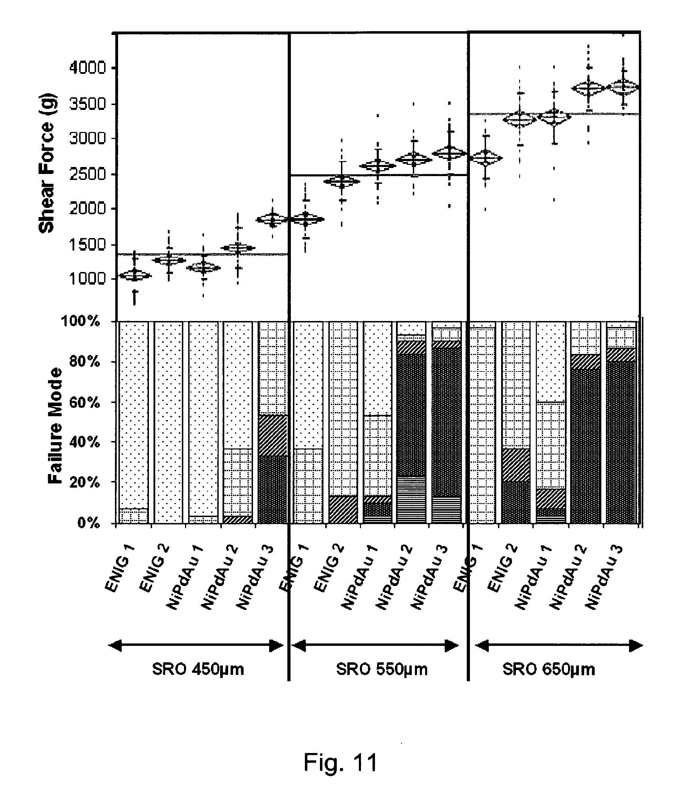

The effect of the SRO diameter was also examined for the different surface finishes as part of the ball shear investigations. Figure 11 presents the results of this examination for the three SROs examined. As expected, higher shear forces are required with increasing SRO diameter. However, the shear force segment of Figure 11 shows a clear trend of higher shear forces for the NiP/PdP/Au finishes in comparison to the ENIG finishes. This same trend is also indicated with respect to failure mode, with a higher incidence of brittle fracture with the ENIG finishes. It is significant to note the dominance of brittle fracture (Modes 4 and 5) for the 450 µm SRO in the failure analysis segment of the chart, although the NiP/PdP/Au finish with thicker palladium did perform better. Also, the NiP/PdP/Au surface finishes with thicker deposits of palladium (0.2 µm and 0.3 µm) again result in a higher percentage of the preferred Mode 2 failures. For the two larger SROs there is essentially no significant difference between results for the NiP/PdP/Au-2 and NiP/PdP/Au-3 surface finishes at the higher shear speed testing used in this analysis. However, at the smaller SRO of 450 µm, the additional palladium thickness provides noticeably improved bond strength, as shown by both the shear force and failure mode analysis.

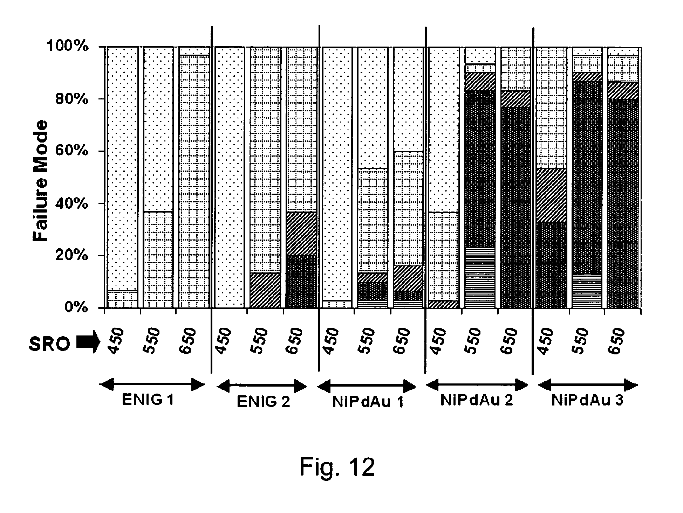

Figure 12 presents a failure mode analysis of the same ball shear results for each SRO according to the surface finish tested. This chart more clearly illustrates the significantly better performance of the NiP/PdP/Au surface finishes that included thicker deposits of palladium (0.2 µm and 0.3 µm).

### Testing Results - Cold Ball Pull

The guidelines and graphics legend for qualifying the four types of cold ball pull failures are given in Figure 9.

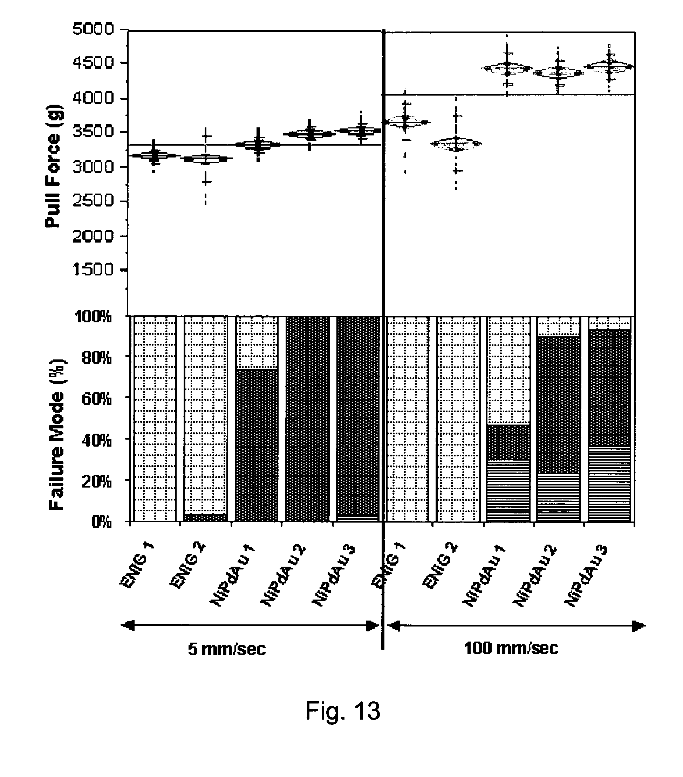

The effect of pull speed on the cold ball pull results is presented in Figure 13. Similar to the ball shear results, the higher pull speed (100 mm/sec) resulted in somewhat higher pull forces for all surface finishes tested. Also, as was the case with ball shear testing, the NiP/PdP/Au finishes performed better than the ENIG finishes at both pull speeds. Overall, although some tendency towards increased brittle fracture mode can be seen by comparing the results of the higher pull speed to the lower, the contrast is not as significant as demonstrated by the ball shear investigations (refer to Figure 10 for comparison). One explanation is that an even higher pull speed (greater than 100 mm/sec) may be required to sufficiently test the bond integrity. However, the increased incidence of pad pull-out (shown at the higher speed) suggests that speeds greater than 100 mm/sec may only lead to an increased number of pad pull-out and provide little additional information.

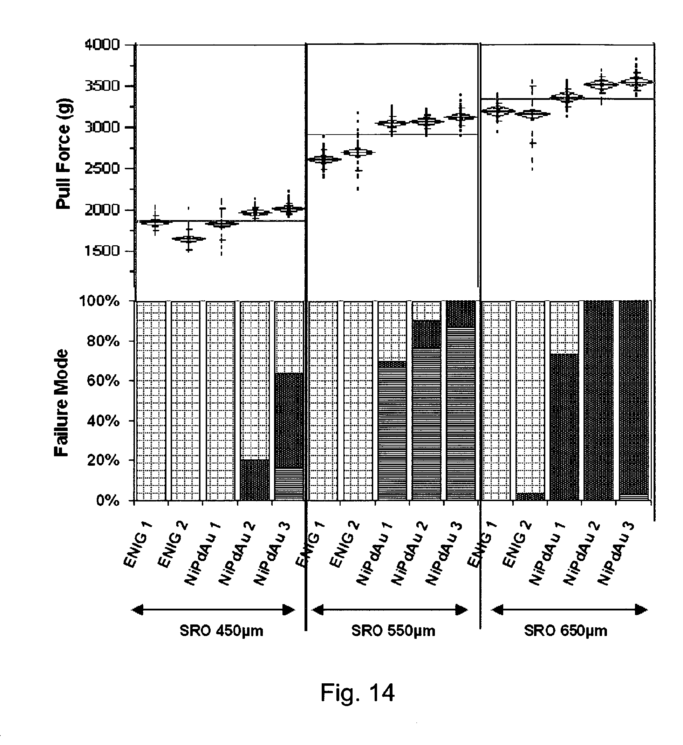

The effect of SRO in relation to cold ball pull testing is presented graphically in Figure 14, evaluated at a constant pull speed of 5 mm/sec. As expected, the similar trend of higher pull forces associated with increasing SRO is continued. Also, the overall performance of the NiP/PdP/Au finishes was significantly better in comparison to the ENIG finishes in terms of both pull force and failure mode. Similar to the results of the ball shear testing, the highest incidence of brittle fracture was reported for the SRO diameter of 450 µm. The extreme occurrence of pad pull-out for all NiP/PdP/Au finishes in combination with the 450 µm SRO is not readily explainable. It may relate to a combination of stress factors specifically associated with the smaller SRO and the 760 µm solder ball, since this same solder ball was used with the SRO of 650 µm. As shown, with the larger SRO, the preferred Mode 2 failure is the dominant result.

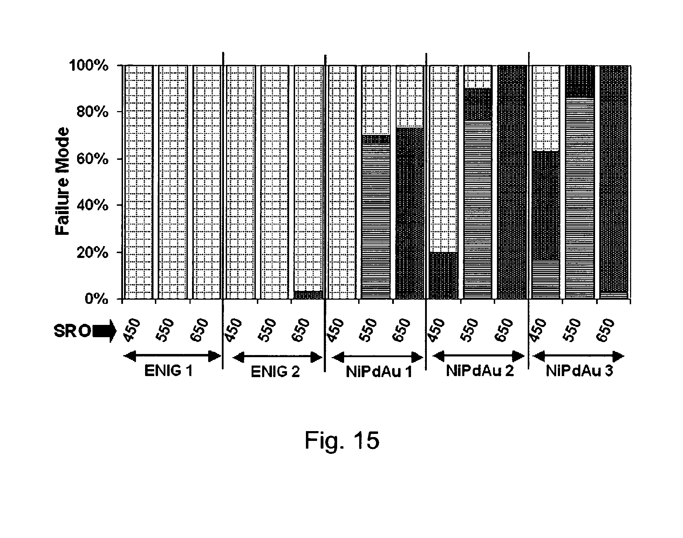

As another means of interpreting the data, Figure 15 presents a failure mode analysis of the same cold ball pull results for each SRO according to the NiP/PdP/Au surface finish tested. Figure 15 dramatically illustrates the superior performance of the NiP/PdP/Au surface finishes with thicker deposit of palladium (0.2 µm and 0.3 µm). Again, no apparent explanation is seen for the extremely high incidence of pad pull-out that was reported for the NiP/PdP/Au finishes coupled with the 550 µm SRO.

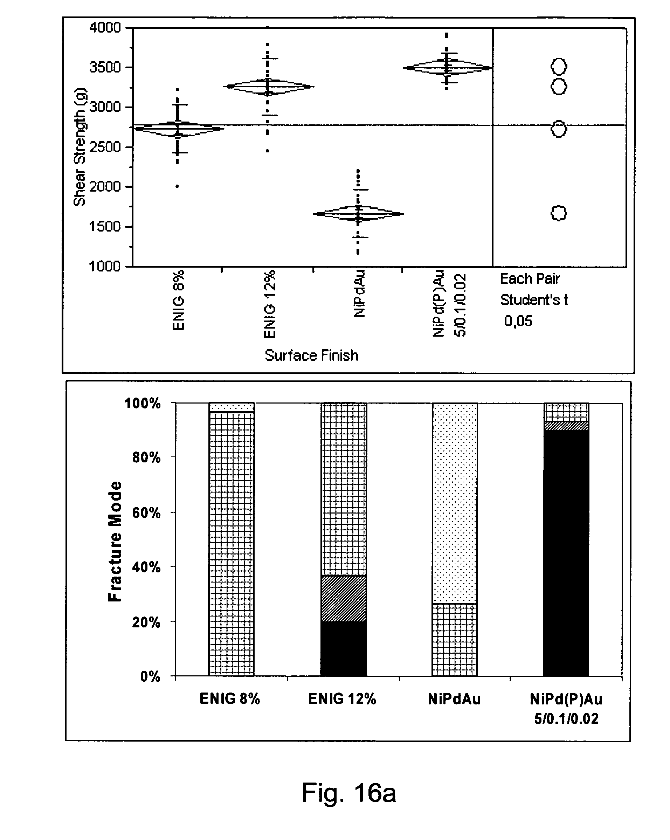

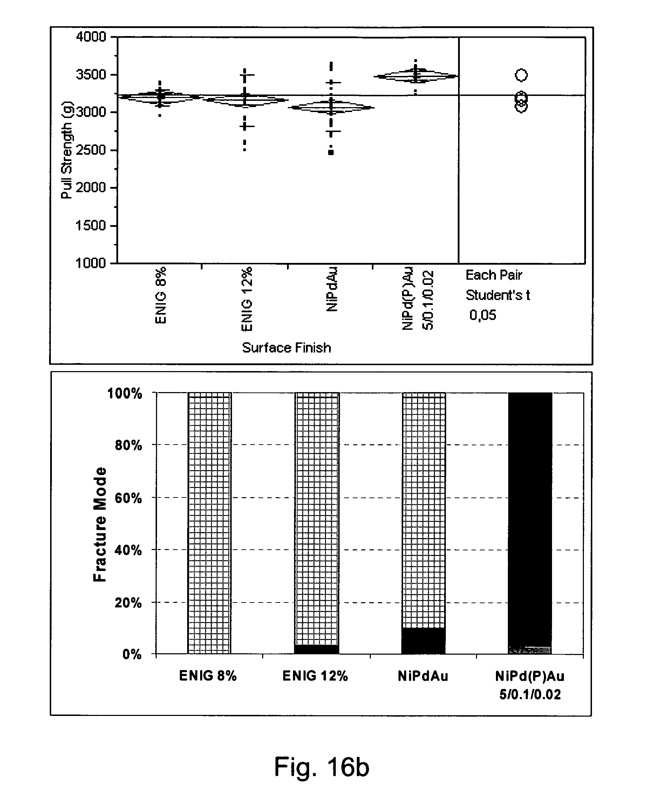

Further experiments were conducted to investigate cold ball pull and high speed shear fracture mode and pull strength or shear strength results, respectively, for different layer assemblies. Figure 16 presents a failure mode analysis comparison of ENIG-1 ("ENIG 8 %"), ENIG-2 ("ENIG 12 %"), NiP/Pd/Au ("NiPdAu") (Comparative Examples) and NiP/PdP/Au ("NiPd(P)Au"; Example of the Invention), the latter having 5 µm NiP, 0.1 µm PdP and 0.02 µm Au. Figure 16a relates to results obtained with the Ball Shear Test and Figure 16b relates to results obtained with the Cold Ball Pull Test. It is shown that only the layer assembly of the invention (NiP/PdP/Au) results in a considerable ratio of fracture mode 2 (fracture to an extent of greater than 95 % within the bulk solder). Cold Ball Pull Testing even results in 100 % fracture modes 1 and 2 (fracture mode 1: pad pullout; fracture mode 2 as given before). A very clear result from this comparison is that using the NiP/Pd/Au layer assembly does not lead to satisfactory results because in this case considerable or 100 % fracture occurs at the interface.

In further investigations fracture mode was also analyzed on IC substrates (semiconductor substrates). Comparison was made with ENIG-1, ENIG-2, NiP/PdP/Au-1, NiP/PdP/Au-2 and NiP/PdP/Au-3. Failure mode primarily detected was pad pull out (with the exception of ENIG-1).

### Testing Results - Intermetallic Examination

The results presented to this point indicate that the NiP/PdP/Au finishes with thicker palladium deposit achieved superior ball shear and cold ball pull results in comparison to both ENIG finishes and to the NiP/PdP/Au finish with thin palladium. To determine the reason for this apparently improved performance, the intermetallic compounds (IMC) of the finishes were examined.

Regarding ENIG, it was reported in previous studies that fractures for the finishes similar to ENIG-1 (nickel with medium phosphorus content) generally occurred closer to the IMC, as opposed to further into the bulk solder in the case of the finishes similar to ENIG-2 (K.Johal, S.Lamprecht, H.J.Schreier, H.Roberts; "Impacts of Bulk Phosphorus Content of Electroless Nickel Layers to Solder Joint Integrity and their Use as Gold- and Aluminum-Wire Bond Surfaces", SMTA 9^{th} Annual Pan Pacific Microelectronics Symposium; January 2004). The formation of nickel-tin IMCs with respect to ENIG finishes is already well documented. The further evaluation presented herein below will concentrate on the NiP/PdP/Au finishes, specifically with 0.05 µm and 0.3 µm palladium deposits.

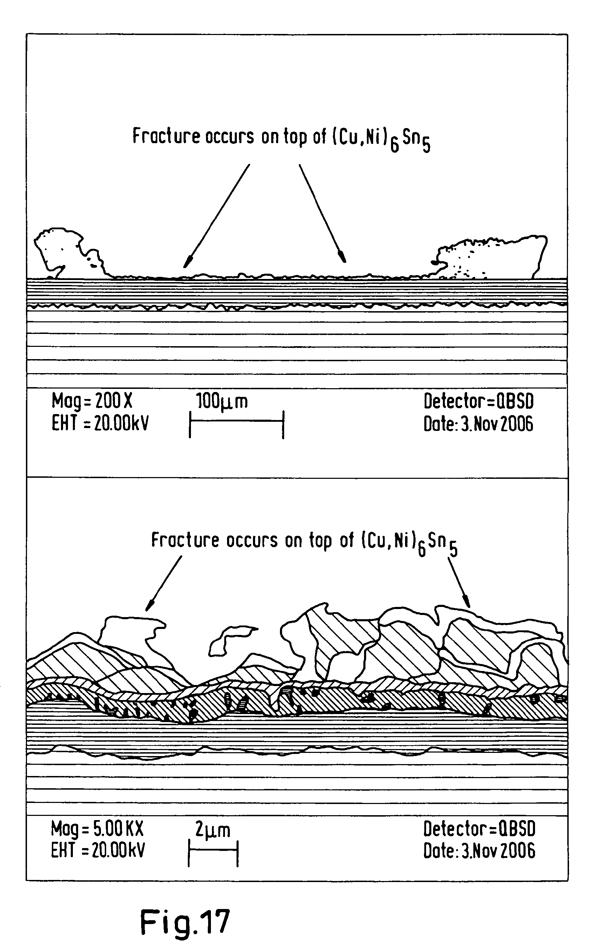

Figure 17 presents SEM photographs of a solder joint of a NiP/PdP/Au solder ball after bond testing, showing the result of major interfacial fracture. As shown at higher magnification, the fracture clearly occurs along the plane where the bulk solder meets the surface of the (Cu,Ni)₆Sn₅ IMC. This finding is typical of other solder joints that were examined with this defect.

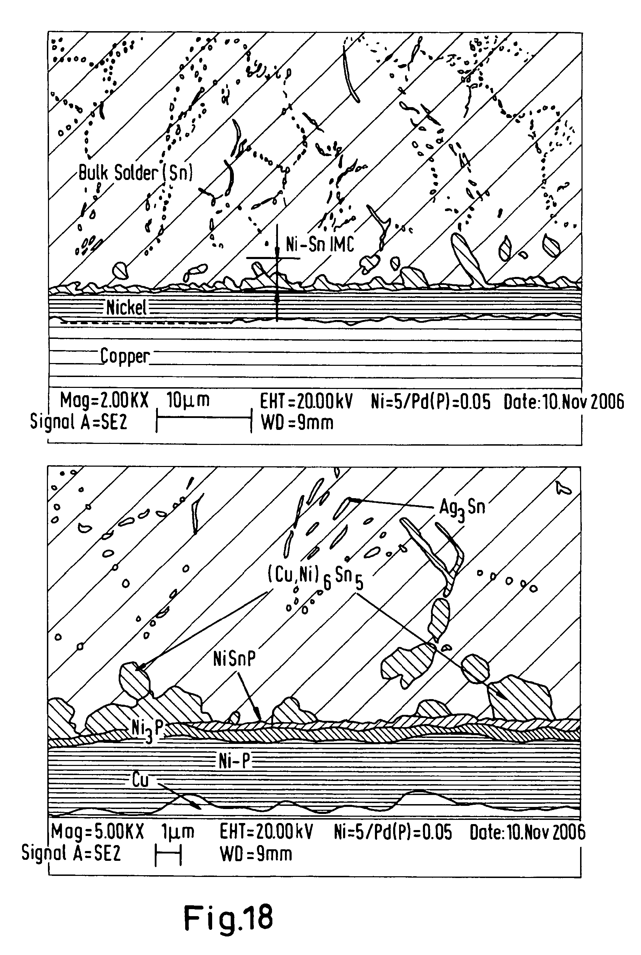

Figure 18 shows cross-sectional SEM photographs of the nickel-tin IMC of a NiP/PdP/Au solder ball, created after one Pb-free solder reflow of the NiP/PdP/Au finish with 0.05 µm palladium-phosphorus. As shown, a portion of the nickel deposit has been converted to create the (Cu,Ni)₆Sn₅ IMC. Also present are a thinner NiSnP IMC and a phosphorus-rich Ni₃P layer, located directly above the originally plated Ni-P deposit.

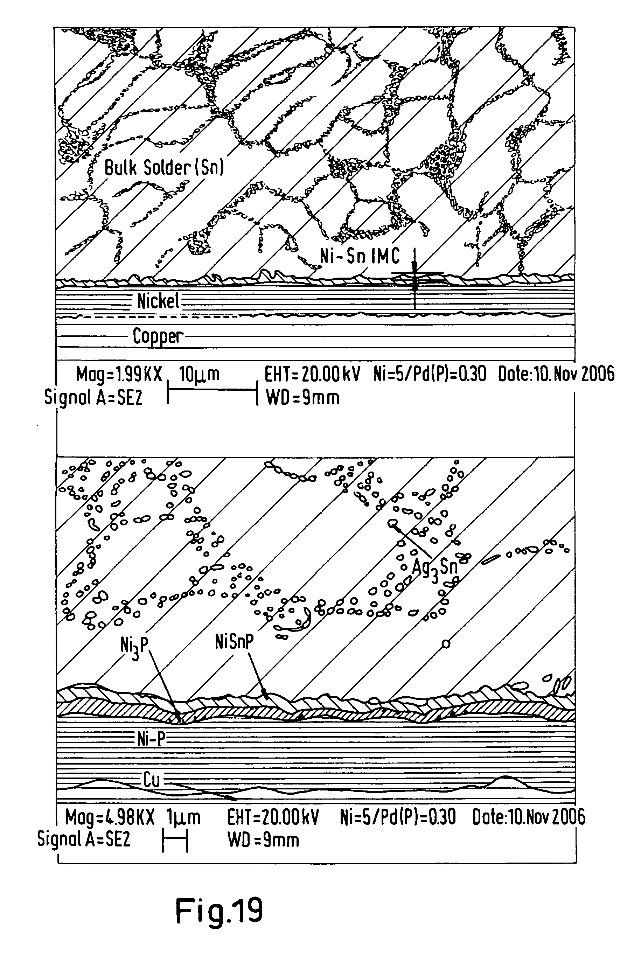

For the NiP/PdP/Au finish with 0.3 µm palladium, the nickel-tin IMC created after one Pb-free solder reflow is shown in Figure 19. In comparison to the previous figure, little or no (Cu,Ni)₆Sn₅ IMC is evident. Only the relatively thin NiSnP IMC can be seen, even at the higher magnification. The remaining Ni-P layer is also somewhat thicker, while the phosphorus-rich Ni₃P layer is noticeably thinner.

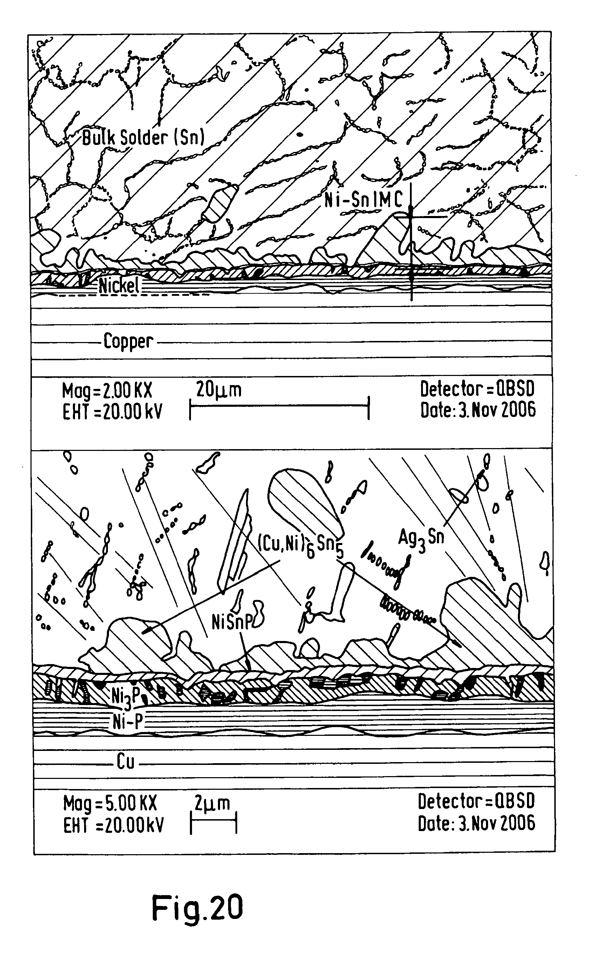

The investigations were continued in an effort to determine if the formation of the IMCs on both finishes, ENIG and NiP/PdP/Au, would be further affected as a result of additional Pb-free solder reflow operations. As such, IMC investigations were also performed following five Pb-free solder reflow cycles. Figure 20 shows SEM photographs of the nickel-tin IMC created after five such reflows on the NiP/PdP/Au finish with the thinner palladium deposit.

As can be seen, considerably more of the nickel deposit has been converted to form more (Cu,Ni)₆Sn₅ IMC, as well as a much thicker Ni₃P layer. As a result, the originally plated NiP deposit has been significantly reduced in thickness to approximately 1.5 µm.

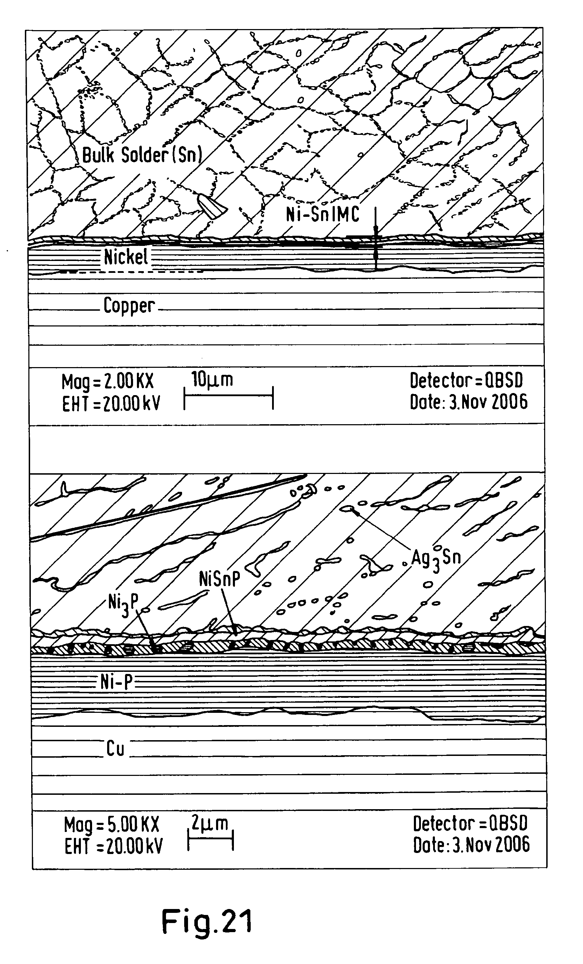

Figure 21 shows the nickel-tin IMC created after five reflows on the NiP/PdP/Au-3 finish. As shown in this Figure, a more definable Ni₃P layer has been formed. Also, the thickness of the originally plated Ni-P layer has been reduced in comparison to the deposit shown after one solder reflow, although still measurably thicker than that of the NiP/PdP/Au-1 shown in Figure 20. It is important to note that there is still no evidence of (Cu,Ni)₆Sn₅ IMC growth. The NiSnP IMC does not look significantly different from the SEM images after one reflow (refer to Figure 19).

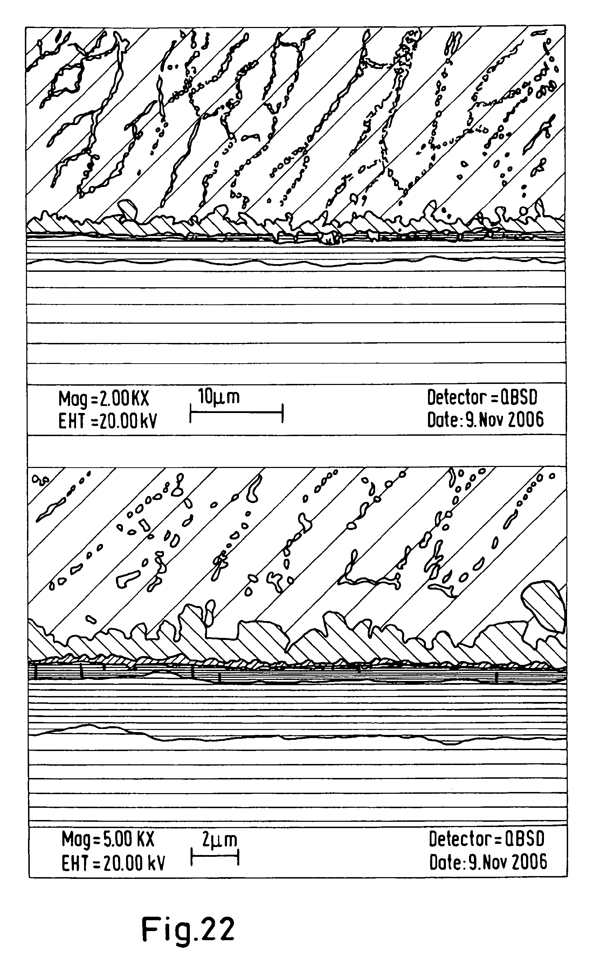

Further investigations were made with a layer assembly comprising a pure palladium sub-layer (0.1 µm thick) instead of a palladium-phosphorus sub-layer. Figure 22 shows SEM photographs of cross sections of the ball/substrate interface, unrevealing IMC created after five reflows on the NiP/Pd/Au finish.

As such, the palladium layer seems to act as a barrier between the underlying nickel and Pb-free solder ball. It is further proposed that the relative absence of the (Cu,Ni)₆Sn₅IMC is directly related to the superior performance of the NiP/PdP/Au surface finishes having thicker palladium deposit in comparison to the other finishes examined. Thus, layer assemblies having a palladium-phosphorus sub-layer being 0.1 µm thick or thicker than 0.1 µm, preferably thicker than 0.15 µm, even more preferably thicker than 0.2 µm and most preferably thicker than 0.3 µm, are preferred over those layer assemblies in which the palladium-phosphorus sub-layer is thinner (the latter providing only poor fracture modes). If five reflows are made on the solder interconnections palladium-phosphorus thickness in the layer assemblies should be at least 0.3 µm (thus achieving good fracture modes and good shear forces). Further, it has turned out that SAC405 alloy solder gives even better fracture modes and slightly higher shear strength than SAC 305 alloy solder. Best results are thus achieved with SAC405 alloy solder and palladium-phosphorus sub-layer thickness of at least 0.3 µm.

Only very poor performance was achieved with ENIG-1 (8 wt.-% phosphorus) and with NiP/Pd/Au (pure palladium), compared to NiP/PdP/Au. ENIG-2 (12 wt.-% phosphorus) performs better, but is not as good as NiP/PdP/Au. In the case of ENIG-2, intermetallics differ from those which form if NiP/PdP/Au is used: ENIG-2 results in stronger build-up of NiPSn intermetallic.

Gold wire bonding data at NiP/PdP/Au (Example according to the Invention) and NiP/Pd/Au (Comparative Example) (layer design Table 5) showed that failure mode was that heel break did not occur to a considerable extent if the specimen were not baked following bonding. Best results were achieved with NiP/PdP/Au with PdP thickness of 0.3 µm because in this case no heel break occurred and neck break percentage was highest.

**Table 5: Layer Design for Gold Wire Bonding**

| Surface Finish | Ni [µm] | PdP or Pd [µm] | Au [µm] |
|---|---|---|---|
| NiP/PdP/Au | 6.2 | 0.05 | 0.01 |
| NiP/PdP/Au | 6.16 | 0.15 | 0.01 |
| NiP/PdP/Au | 6.03 | 0.28 | 0.01 |
| NiP/Pd/Au | 7.45 | 0.09 | 0.02 |

Wetting balance data investigating the NiP/PdP/Au layer assembly showed excellent wetting in 95.7Sn3.8Ag0.5Cu alloy solder.

Two different test methodologies were employed in these investigations. Both, the ball shear test and cold ball pull test, have now been used in solder joint reliability examinations. In general, the results of these methods do follow certain basic trends in terms of forces and failure modes for the tested samples. However, as shown herein above, the results obtained from both methodologies are very much dependent on specific test parameters, particularly the selected shear and pull speed. Further JEDEC Standard No. 22B117, "Solder Ball Shear" (JEDEC Standard - Solder Ball Shear (JESD22-B117), JEDEC Solid State Technology Association, October 2006) provides valuable and needed guidance for conducting such investigations and helps to standardize the performance of such tests. However, the standard does not provide specific details regarding shear speeds, other than to identify low-speed and high-speed shear by definition.

The investigations presented herein above are based on a comprehensive DOE focused on identification of preferred surface finishes for IC substrates (ball side and C4 side) used in flip chip BGAs primarily for CPU (central processing unit) and MPU (micro-processor unit) applications. However, the findings of these investigations suggest that the NiP/PdP/Au surface should also be considered for evaluation in other Pb-free applications. As shown, the present evaluation has concentrated on the solder joint reliability that can be achieved with the tested surface finishes. However, the NiP/PdP/Au surface finish also offers distinct technology and cost advantages in comparison to processes used for similar applications. The NiP/PdP/Au finish provides an opportunity to combine multiple bonding functions, including both soldering and both gold and aluminum wire bonding on one common surface. Traditionally, gold wire bonding has been accomplished with the use of other surface finish processes (electrolytic nickel/gold or electroless nickel-phosphorus/gold), more costly because of the precious metal consumption. Additional cost savings would be realized as a result of manufacturing process simplification. NiP/PdP/Au is an electroless / immersion type of process, meaning that no electrical bus is required, thus simplifying the process and reducing costs. More importantly, as an electroless / immersion process, it allows a product of finer features to be produced.

Based on the investigations performed in this evaluation, the following conclusions are offered:

Both ball shear and cold ball pull test methodologies can be used to evaluate BGA solder joint reliability. In the respective tests, the selection of shear and pull speeds are critical in terms of the resultant findings. This finding is particularly true in terms of failure mode results. Strictly based on the parameters used in this evaluation, the more demanding test of solder ball bond strength would appear to be the high-speed ball shear testing performed at 1000 mm/sec. To obtain comparable results with cold ball pull testing, a higher pull speed than that used (100 mm/sec) may be required. For the respective test methods, selection of the higher shear speed or higher pull speed will encourage failure modes more specifically related to brittle (interfacial) fracture.

For the samples tested, the diameter of the solder resist opening (SRO) has an influence on both ball shear and cold ball pull results. Generally, solder joints with a larger SRO are able to withstand greater shear and pull forces and exhibit a higher percentage of preferred (ductile) failure mode.

For all shear and pull speeds investigated, the NiP/PdP/Au finishes with thicker palladium deposit (0.2 µm and 0.3 µm) are able to withstand measurably greater shear force and exhibit significantly lower incidence of interfacial fracture. It has also been determined that nickel thickness variation (3.0 to 7.0 µm) does not significantly impact ball shear or cold ball pull results.

For the samples tested, solder joint failure primarily caused by brittle (interfacial) fracture were found to occur at the interface of the bulk solder to the (Cu,Ni)₆Sn₅ IMC. SEM analysis indicate that the NiP/PdP/Au finishes with thicker palladium deposit (0.2 µm and 0.3 µm) show little or none of this IMC in the solder joint following one and five Pb-free solder reflow cycles. In C4 soldering (Sn96.5Ag3.5 solder paste was printed on 120 µm pads on the C4-side of the IC substrates in such a way that after reflow soldering 60 µm high solder bumps were formed) a band of PdSn₄ IMC shows up after one reflow over the interface between nickel and Pb-free solder, if a 0.3 µm thick PdP sub-layer is used. After two reflows such PdSn₄ IMC is almost evenly distributed in such small solder joints.

## Claims

1. A layer assembly comprising at least first and second sub-layers, wherein
a. said first sub-layer comprises a first material, said first material comprising nickel and phosphorus and said first sub-layer being in contact with said second sub-layer; and
b. said second sub-layer comprises a second material, said second material comprising palladium and phosphorus and said second sub-layer being in contact with said first sub-layer and wherein said second sub-layer is at least 0.1 µm thick.

2. The layer assembly according to claim 1, further comprising a third sub-layer, wherein
b. said second sub-layer is furthermore in contact with said third sub-layer; and
c. said third sub-layer comprises a third material, said third material consisting of gold or a gold alloy and said third sub-layer being in contact with said second sub-layer.

3. The layer assembly according to any one of the preceding claims, wherein said third sub-layer is from 10 nm to 20 nm thick.

4. The layer assembly according to any one of the preceding claims, wherein said second sub-layer is at least 0.3 µm thick.

5. The layer assembly according to any one of the preceding claims, wherein said second sub-layer is at most 2.0 µm thick.

6. The layer assembly according to any one of the preceding claims, wherein said second material consists of from 94 wt.-% to 96 wt.% of palladium and from 6 wt.-% to 4 wt.% of phosphorus.

7. The layer assembly according to any one of the preceding claims, wherein said first sub-layer is from 5 µm to 10 µm thick.

8. The layer assembly according to any one of the preceding claims, wherein said first material consists of from 90 wt.-% to 93 wt.-% of nickel and from 10 wt.-% to 7 wt.-% of phosphorus.

9. A method of forming a layer assembly comprising at least first and second sub-layers according to any one of claims 1 - 8, said method comprising the steps of:
a. providing a circuit carrier comprising a carrier corpus and a copper structure provided on one or both sides of said carrier corpus;
b. depositing on said copper structure said first sub-layer; and
c. depositing on said first sub-layer said second sub-layer.

10. The method according to claim 9, wherein said layer assembly additionally comprises a third sub-layer and wherein the method further comprises
d. depositing on said second sub-layer said third sub-layer.

11. The method according to claim 10, wherein said method comprises depositing each one of said first, second and third sub-layers by at least one of electroless and immersion plating.

12. The method according to any one of claims 10 and 11, wherein said method comprises depositing said third sub-layer by bringing said circuit carrier into contact with a solution containing a gold ion source and a complexing agent.

13. The method according to any one of claims 9 - 12, wherein said method comprises depositing said second sub-layer by bringing said circuit carrier into contact with a solution containing a palladium ion source and a phosphorus containing reducing agent.

14. The method according to any one of claims 9 - 13, wherein said method comprises depositing said first sub-layer by bringing said circuit carrier into contact with a solution containing a nickel ion source and a phosphorus containing reducing agent.

15. A circuit carrier comprising a carrier corpus and a copper structure provided on one or both sides of said carrier corpus, the copper structure being coated with the layer assembly comprising at least first and second sub-layers according to any one of claims 1 - 8.

16. The circuit carrier according to claim 15, wherein said one or said both sides of said carrier corpus is/are provided with a conformal mask, said conformal mask covering all regions on said one or said both sides of said carrier corpus except those regions on said one or said both sides where the layer assembly is coated on the copper structure.
